(19)

**Europäisches Patentamt**
**European Patent Office**
**Office européen des brevets**

(11) **EP 4 451 343 A1**

(12) **EUROPEAN PATENT APPLICATION**
published in accordance with Art. 153(4) EPC

(43) Date of publication:
**23.10.2024 Bulletin 2024/43**

(21) Application number: **22907150.1**

(22) Date of filing: **24.11.2022**

(51) International Patent Classification (IPC):
***H01L 29/78*** (2006.01)    ***H01L 29/06*** (2006.01)
***H01L 29/872*** (2006.01)

(52) Cooperative Patent Classification (CPC):
**H01L 29/06; H01L 29/78; H01L 29/872**

(86) International application number:
**PCT/JP2022/043259**

(87) International publication number:
**WO 2023/112619 (22.06.2023 Gazette 2023/25)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **19.12.2021 JP 2021205630**

(71) Applicant: **Shindengen Electric Manufacturing Co., Ltd.**
**Tokyo 100-0004 (JP)**

(72) Inventors:
• **HASHIMOTO, Masaki**
  **Asaka-shi Saitama 351-0015 (JP)**
• **SUEMOTO, Ryuji**
  **Asaka-shi Saitama 351-0015 (JP)**
• **SENDA, Satoru**
  **Asaka-shi Saitama 351-0015 (JP)**

(74) Representative: **Wynne-Jones IP Limited**
**Southgate House**
**Southgate Street**
**Gloucester, Gloucestershire GL1 1UB (GB)**

(54) **SEMICONDUCTOR DEVICE**

(57)    [Problem] To provide a semiconductor device capable of suppressing a channel current without increasing manufacturing processes, and capable of accurately forming a channel current suppression structure. [Solution] A semiconductor device 1 according to the present invention includes: a substrate 10; an epitaxial layer 20 formed on the substrate 10; and an insulating film 35 provided on one surface 20a side of the epitaxial layer 20. An active portion 40 provided with a predetermined element and a channel current suppression portion 50 being at a termination portion 70 side and provided outside the active portion 40 are provided on the one surface 20a side of the epitaxial layer 20 via the insulating layer 35. The channel current suppression portion 50 is provided with a trench 51 for suppressing the channel current flowing from the active portion 40 to the termination portion 70.

FIG. 1

EP 4 451 343 A1

# Description

## TECHNICAL FIELD

The present invention relates to a semiconductor device.

## BACKGROUND

In a semiconductor device such as a Schottky barrier diode (SBD), a channel due to a passivation charge may be formed from a trench in an active region, where the main current flows to the termination portion, and a channel current may flow therethrough. For this reason, conventionally, a reverse current of the Schottky barrier diode may be increased, and a channel stopper such as a high-concentration n-plus layer is provided at the termination portion side in order to prevent the channel current that causes the increase in the reverse current. For such a technique, it is possible to refer to the techniques described in Patent Document 1, for example.

## PRIOR ART DOCUMENT

## PATENT DOCUMENT

Patent Document 1: JP 2009-130002 A

## SUMMARY OF THE INVENTION

## PROBLEMS TO BE SOLVED BY THE INVENTION

In the background technology described above, the channel current is prevented, while the number of manufacturing processes increases to provide the channel stopper, resulting in a cost increase. Therefore, it has been desired to develop a technique capable of suppressing the channel current without increasing the number of manufacturing processes. In addition, when a channel stopper is provided, there is a possibility that a structure may become uneven due to influences of processes such as an implant process (ion implantation process), a diffusion process, and other process, so that a channel current suppression structure may not be formed with high accuracy.

The present invention has been made in view of such circumstances, and the purpose of the present invention is to provide a semiconductor device capable of suppressing the channel current without increasing the number of manufacturing processes and accurately forming the channel current suppression structure.

## MEANS FOR SOLVING THE PROBLEMS

In order to solve the above problems, a semiconductor device according to the present invention having a substrate, an epitaxial layer formed on the substrate, and an insulating film provided on one surface side of the epitaxial layer,

wherein on the one surface side of the epitaxial layer, an active portion provided with a predetermined element and a channel current suppression portion being at a termination portion side and provided outside the active portion are provided via the insulating film, and
wherein the channel current suppression portion is provided with a trench for suppressing a channel current flowing from the active portion to the termination portion.

According to the present invention, on the one surface side of the epitaxial layer, the active portion provided with the predetermined element and the channel current suppression portion being at the termination portion side and provided outside the active portion are provided via the insulating film. Further, the channel current suppression portion is provided with the trench for suppressing the channel current flowing from the active portion to the termination portion. Thereby, for example, the trench of the channel current suppression portion can be provided at the same time as the trench of the active portion, while the flow of channel current from the active portion to the termination portion can be interrupted by the trench of the channel current suppression portion. Namely, it is possible to provide the trench in the channel current suppression portion without increasing the number of manufacturing processes and suppress the channel current flowing to the termination portion. In addition, it is possible to accurately form the channel current suppression structure.

The channel current suppression portion can be further provided with an electrode for suppressing the channel current. This makes it possible to further suppress the channel current flowing to the termination portion in combination with the effect of the trench.

The electrode for suppressing the channel current can be an EQR electrode. Thereby, the potential can be held at an equal potential, and the channel current flowing to the terminal portion can be suppressed.

The EQR electrode can have a portion directly provided on the epitaxial layer without interposing the insulating film therebetween. This makes it possible to electrically connect the EQR electrode and the epitaxial layer.

A trench can be provided in the active portion, and a depth dimension and/or a width dimension of the trench provided in the channel current suppression portion can be set to be equal to or greater than a depth dimension and/or a width dimension of the trench provided in the active portion. Thereby, the channel current can be reliably guided to the trench provided in the channel current suppression portion.

The trench provided in the channel current suppression portion can be provided so as to be cut out in a stepped shape at the termination portion side on the one surface side of the epitaxial layer, and the trench having the stepped shape can be configured to expose a lateral side of an outer side thereof. Thereby, the resistance increases and the channel current flowing to the termination portion can be further suppressed.

The trench having the stepped shape can be further provided with a trench at the bottom. Thereby, the trench having the stepped shape and the trench at the bottom work together to further suppress the channel current flowing to the termination portion.

A plurality of trenches in the channel current suppression portion can be provided along the direction in which the channel current flows.

A mesa width of the trench provided in the channel current suppression portion can be set to a width dimension greater than a width of the trench. Thereby, the flow of the channel current can be reliably interrupted by the trench of the channel current suppression portion.

The element can be a diode. This makes it possible to suppress performance deterioration caused by the reverse current in the diode generated by the channel current described above.

The diode can be a Schottky barrier diode. Thereby, in the Schottky barrier diode having a large reverse current, the effect of suppressing the performance deterioration caused by the reverse current is further increased.

## EFFECTS OF THE INVENTION

According to the present invention, the channel current can be suppressed without increasing the number of manufacturing processes, and the channel current suppression structure can be accurately formed.

## BRIEF DESCRIPTION OF THE DRAWINGS

FIG. 1 is a plan view showing a configuration of a semiconductor device according to a first embodiment of the present invention.

FIG. 2 is an AA front cross-sectional view of FIG. 1 showing the configuration of the semiconductor device.

FIG. 3 is an enlarged front cross-sectional view showing a structure of a trench of the semiconductor device. FIG. 3(a) is an enlarged front cross-sectional view showing a structure of a first trench. FIG. 3(b) is an enlarged front cross-sectional view showing a structure of a second trench.

FIG. 4 is a plan view showing a configuration of a semiconductor device according to a second embodiment of the present invention.

FIG. 5 is a BB front cross-sectional view of FIG. 4 showing the configuration of the semiconductor device.

FIG. 6 is a front cross-sectional view showing another configuration of the semiconductor device.

FIG. 7 is a front cross-sectional view showing yet another configuration of the semiconductor device.

FIG. 8 is a front cross-sectional view showing still another configuration of the semiconductor device.

FIG. 9 is a front cross-sectional view showing a modification example of the semiconductor device.

FIG. 10 is a front cross-sectional view showing a different modification example of the semiconductor device.

FIG. 11 is a front cross-sectional view showing yet a different modification example of the semiconductor device.

FIG. 12 is a front cross-sectional view showing still a different modification example of the semiconductor device.

FIG. 13 is a front cross-sectional view showing further still a different modification example of the semiconductor device.

FIG. 14 is a front cross-sectional view showing another modification example of the semiconductor device.

FIG. 15 is a front cross-sectional view showing yet another modification example of the semiconductor device.

FIG. 16 is an enlarged front cross-sectional view showing the structure of the second trench of the semiconductor device according to the yet another modification example.

FIG. 17 is a front cross-sectional view showing still another modification example of the semiconductor device.

FIG. 18 is a front cross-sectional view showing further still another modification example of the semiconductor device.

FIG. 19 is a front cross-sectional view showing an application example of the semiconductor device.

FIG. 20 is a front cross-sectional view showing another application example of the semiconductor device.

FIG. 21 is a front cross-sectional view showing yet another application example of the semiconductor device.

FIG. 22 is a front cross-sectional view showing still another application example of the semiconductor device.

FIG. 23 is a front cross-sectional view showing further still another application example of the semiconductor device.

FIG. 24 is a plan view showing another application example of the semiconductor device.

FIG. 25 is a plan view showing yet another application example of the semiconductor device.

## MODE FOR CARRYING OUT THE INVENTION

[FIRST EMBODIMENT]

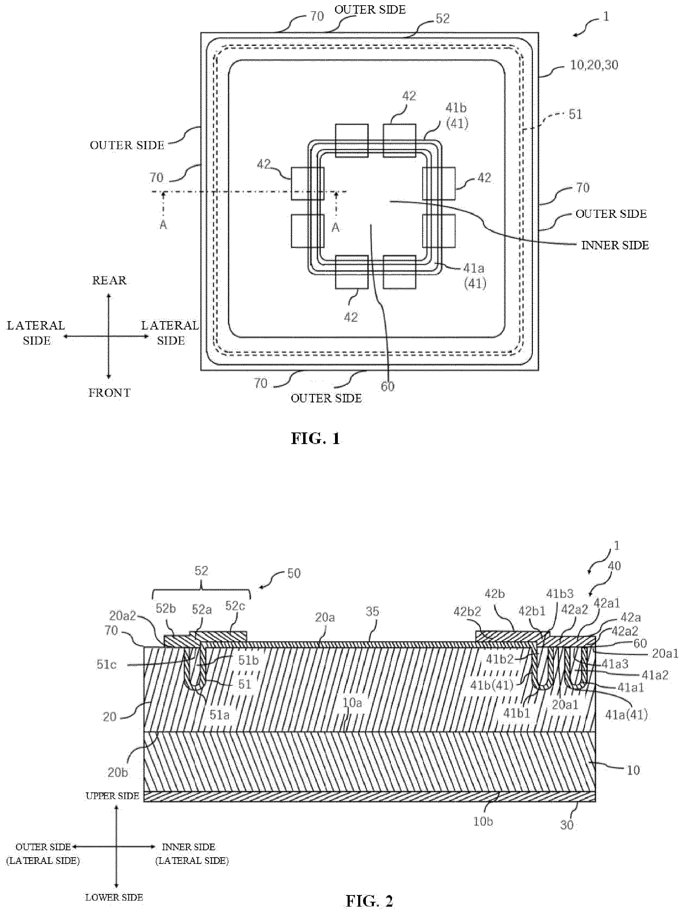

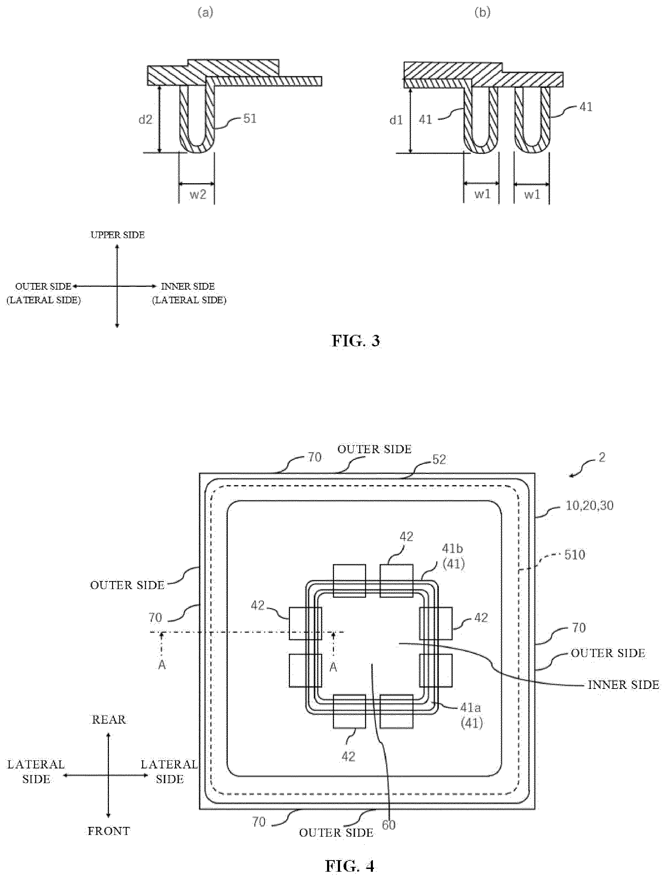

A semiconductor device 1 according with the first embodiment of the present invention will be described in detail with reference to FIGS. 1 to 3. FIG. 1 is a plan view showing the configuration of a semiconductor device 1 according to a first embodiment of the present invention. FIG. 2 is an AA front cross-sectional view of FIG. 1 showing the configuration of a semiconductor device. FIG. 3 is an enlarged front cross-sectional view showing the structure of a trench of the semiconductor device. In the following description, when viewed from a substrate 10 of the semiconductor device 1, an epitaxial layer 20 side is considered to be an upper side, a cathode electrode or the like 30 side is considered to be a lower side, a central portion 60 side of the semiconductor device 1 is considered to be an inner side, and a termination portion 70 side is considered to be an outer side. In this regard, each of the directions including other directions shall be clearly indicated in the figures.

An overview of the semiconductor device 1 according to the first embodiment of the present invention will be explained with reference to FIGS. 1 to 3. The semiconductor device 1 has a rectangular shape in a plan view, and has a substrate 10, an epitaxial layer 20, a drain electrode or a cathode electrode 30 (for example, a drain electrode in a MOSFET, a cathode electrode in a diode, hereinafter referred to as a cathode electrode or the like 30), an insulating film 35, an active portion 40, and a channel current suppression portion 50.

The substrate 10 can be formed of a predetermined conductive material so as to have a plate shape. The substrate 10 is a single crystal substrate, and the epitaxial layer 20 is formed on one surface 10a side which is an upper surface side of the substrate 10. The cathode electrode or the like 30 is provided on the other surface 10b side which is a lower surface side of the substrate 10. The cathode electrode or the like 30 can be formed of a conductive material such as metal. A predetermined potential difference is generated between the cathode electrode or the like 30 and the active portion 40, so that the current flows through the active portion 40, causing the active portion 40 to function.

The epitaxial layer 20 can be formed by epitaxially growing the entire surface on the one surface 10a side of the substrate 10. The insulating film 35 is provided at a predetermined position on one surface 20a side which is an upper surface side of the epitaxial layer 20. The active portion 40 and the channel current suppression portion 50 are provided on the one surface 20a side of the epitaxial layer 20 via the insulating film 35. That is, the active portion 40 and the channel current suppression portion 50 are insulated from the epitaxial layer 20 via the insulating film 35.

The active portion 40 is provided in a region of the central portion 60 side (inner side) through which the main current flows. The active portion 40 is provided with a trench 41. The trench 41 has an inner trench 41a provided at the central portion 60 side (inner side) and an outer trench 41b provided at the termination portion 70 side (outer side).

The trenches 41a and 41b are provided so as to bury a predetermined portion on the one surface 20a side of the epitaxial layer 20. Each of the trenches 41a and 41b has a groove shape provided so as to go around the one surface 20a side of the epitaxial layer 20 with a predetermined depth dimension (groove depth dimension) d1 and a width (trench width) dimension w1 in a U-shaped cross section thereof. The insulating film 35 is provided on each of embedded inner surfaces 41a1 and 41b1 of the trenches 41a and 41b. That is, the trenches 41a and 41b are insulated with regard to the epitaxial layer 20. In a space surrounded by the inner surfaces 41a1 and 41b1 of the trenches 41a and 41b, conductive materials 41a2 and 41b2 are respectively filled up to upper ends of the trenches 41a and 41b via the insulating film 35. The openings 41a3 and 41b3 at the upper ends of the trenches 41a and 41b are respectively closed by the conductive materials 41a2 and 41b2. The conductive materials 41a2 and 41b2 can be, for example, various conductive materials such as polysilicon, impurity doped silicon, and metal.

The active portion 40 is provided with a diode 42. The diode 42 can be a Schottky barrier diode (SBD) 42. The Schottky barrier diode 42 includes a Schottky electrode 42a and a field plate electrode 42b. The Schottky electrode 42a is an electrode portion through which the main current flows and serves as a main function of the Schottky barrier diode 42. The field plate electrode 42b is an electrode portion that serves to reduce an electric field intensity. The Schottky electrode 42a and the field plate electrode 42b are provided in a continuous manner so as to have a stepped shape.

The Schottky electrode 42a includes a first electrode portion 42a1 and a second electrode portion 42a2. The first electrode portion 42a1 is provided so as to close the opening 41a3 of the inner trench 41a. The first electrode portion 42a1 is directly bonded to the conductive material 41a2 filled in the inner trench 41a without interposing the insulating film 35 therebetween.

The second electrode portion 42a2 is an electrode portion extending in a short shape from the first electrode portion 42a1 toward the center portion 60 side (inner side) and toward the termination portion 70 side (outer side). The second electrode portion 42a2 is directly bonded to the one surface 20a of the epitaxial layer 20. That is, the insulating film 35 is not provided on a peripheral portion 20a1 (the active portion terminal 20a1) of the opening 41a3 of the trench 41a in the one surface 20a of the epitaxial layer 20, and the second electrode portion 42a2 is a portion directly provided on the epitaxial layer 20 without interposing the insulating film 35 therebetween.

The field plate electrode 42b has a first electrode portion 42b1 and a second electrode portion 42b2.

The first electrode portion 42b1 is an electrode portion continuous with the second electrode portion 42a2 of the Schottky electrode 42a.

The first electrode portion 42b1 is provided so as to close the opening 41b3 of the outer trench 41b. The first electrode portion 42b1 is directly bonded to the conductive material 41b2 filled in the outer trench 41b without interposing the insulating film 35 therebetween.

The second electrode portion 42b2 is an electrode portion extending from the first electrode portion 42b1 toward the terminal portion 70 side (outer side). The second electrode portion 42b2 is provided on the epitaxial layer 20 via the insulating film 35.

The channel current suppression portion 50 is provided in a region of the termination portion 70 side (outer side). That is, the channel current suppression portion 50 is provided outside the active portion 40 so as to surround the active portion 40. Similarly to the active portion 40, the trench 51 is provided in the channel current suppression portion 50. The trench 51 can suppress a channel current flowing from the active portion 40 to the terminal portion 70 side (outer side).

The trench 51 is provided so as to bury a predetermined portion on the one surface 20a side of the epitaxial layer 20. The trench 51 has a groove shape provided so as to go around the one surface 20a side of the epitaxial layer 20 with a predetermined depth dimension (groove depth dimension) d2 and a width (trench width) dimension w2 in a U-shaped cross section thereof. The depth dimension d2 of the trench 51 is set to be equal to or greater than the depth dimension d1 of each of the trenches 41a and 41b provided in the active portion 40. The width (trench width) dimension w2 of the trench 51 is set to be equal to or greater than the width (trench width) dimension w1 of each of the trenches 41a and 41b provided in the active portion 40. The insulating film 35 is provided on an embedded inner surface 51a of the trench 51. That is, the trench 51 is insulated from the epitaxial layer 20. In a space surrounded by the inner surface 51a of the trench 51, a conductive material 51b is filled up to an upper end of the trench 51 via the insulating film 35. An opening 51c at the upper end of the trench 51 is closed by the conductive material 51b. The conductive material 51b can be, for example, various conductive materials such as polysilicon, impurity doped silicon, and metal.

The channel current suppression portion 50 is further provided with an electrode 52 that suppresses the channel current. The electrode 52 that suppresses the channel current can be an EQR (EQui-potential Ring) electrode 52. The EQR electrode 52 is provided so as to go around the one surface 20a side of the epitaxial layer 20 in a ring shape. The EQR electrode 52 can bring predetermined EQR regions to an equal potential. The active portion 40 is provided in a ring-shaped inner region of the EQR electrode 52.

The EQR electrode 52 can be formed of a conductive material. The EQR electrode 52 includes a first electrode portion 52a, a second electrode portion 52b, and a third electrode portion 52c. The first electrode portion 52a, the second electrode portion 52b, and the third electrode portion 52c are provided in a continuous manner so as to have a stepped shape.

The first electrode portion 52a is provided to close the opening 51c of the trench 51. The first electrode portion 52a is directly bonded to the conductive material 51b filled in the trench 51 without interposing the insulating film 35 therebetween.

The second electrode portion 52b is an electrode portion extending in a short shape from the first electrode portion 52a toward the terminal portion 70 side (outer side).

The second electrode portion 52b is directly bonded to the one surface 20a of the epitaxial layer 20. That is, the insulating film 35 is not provided in a peripheral portion 20a2 at the termination portion 70 side of the opening 51c of the trench 51 in the one surface 20a of the epitaxial layer 20, and the second electrode portion 52b is a portion directly provided on the epitaxial layer 20 without interposing the insulating film 35 therebetween. The EQR electrode 52 is electrically connected to the epitaxial layer 20 via the second electrode portion 52b directly provided on the epitaxial layer 20.

The third electrode portion 52c extends from the first electrode portion 42b1 toward the center portion 60 side (inner side). The third electrode portion 52c is provided in the epitaxial layer 20 via the insulating film 35.

In the semiconductor device 1 configured as described above, when the main current is made to flow through the diode 42 of the active portion 40, more specifically through the Schottky barrier diode 42, to make it function, a channel due to charges of a passivation and the like is formed from the Schottky barrier diode 42 toward the termination portion 70 side (outer side), and the channel current flows therethrough. However, by providing the trench 51 in the channel current suppression portion 50, the flow of the channel current from the active portion 40 toward the termination portion 70 side (outer side) can be interrupted by the trench 51 of the channel current suppression portion 50. Further, the channel current flowing toward the termination portion 70 side (outer side) can be suppressed. In addition, since the trench 51 is also provided in the active portion 40 similarly, the trenches 41a and 41b of the active portion 40 and the trench 51 of the channel current suppression portion 50 can be provided at the same time. Namely, it is possible to accurately form the channel current suppression structure without increasing the number of manufacturing processes and suppress the channel current.

The channel current suppression portion 50 can be further provided with the electrode 52 that suppresses the channel current, thereby further suppressing the channel current flowing toward the termination portion 70 side (outer side) in combination with the effect of the trench 51.

That is, by using the EQR electrode 52 as the electrode 52 that suppresses the channel current, the cathode electrode or the like 30 and the channel current suppression portion 50 can be held at an equal potential, and the channel current flowing toward the terminal portion 70 side (outer side) can be suppressed.

Further, the EQR electrode 52 can have the second electrode portion 52b that is directly provided on the epitaxial layer 20 without interposing the insulating film 35 therebetween. This makes it possible to electrically connect the EQR electrode 52 and the epitaxial layer 20. As a result, the other surface 20b side, which is the lower surface side of the epitaxial layer 20, and the EQR electrode 52 can be set to an equal potential, and the channel current flowing from the active portion 40 toward the terminal portion 70 side (outer side) can be suppressed.

Further, by setting the depth dimension d2 of the trench 51 provided in the channel current suppression portion 50 to be equal to or greater than the depth dimension d1 of the trench 41 provided in the active portion 40, and by setting the width dimension w2 of the trench 51 provided in the channel current suppression portion 50 to be equal to or greater than the width dimension w1 of the trench 41 provided in the active portion 40, the flow of the channel current can be further interrupted by the trench 51 provided in the channel current suppression portion 50.

Further, by using the diode 42 as the element provided in the active portion 40, it is possible to suppress the performance deterioration which is caused by the reverse current of the diode 42 generated by the above-mentioned channel current.

By using the Schottky barrier diode 42 as the diode 42, it is possible to further increase the effect of suppressing the performance deterioration caused by the reverse current in the Schottky barrier diode 42 having the large reverse current.

[SECOND EMBODIMENT]

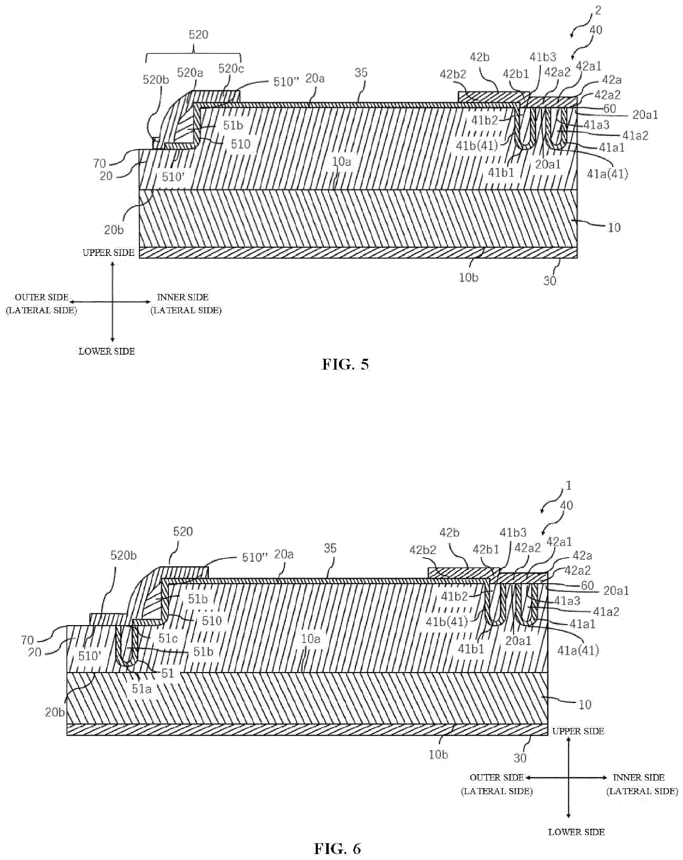

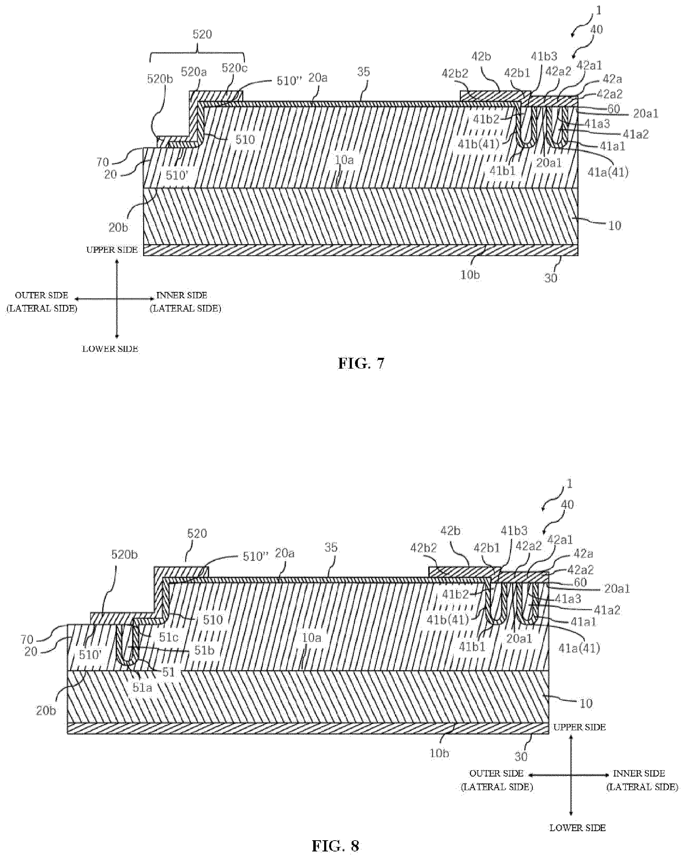

Next, a semiconductor device 2 according to a second embodiment of the present invention will be described in detail with reference to FIGS. 4 to 8. FIG. 5 is a BB front cross-sectional view of FIG. 4 showing the configuration of the semiconductor device 2. FIG. 6 is a front cross-sectional view showing another configuration of the semiconductor device 2. FIG. 7 is a front cross-sectional view showing yet another configuration of the semiconductor device 2. FIG. 8 is a front cross-sectional view showing still another configuration of the semiconductor device 2. In the following description and FIG. 4 to FIG. 8, configurations having the same reference numerals as those of the above-described embodiment and configurations with no description are the same as those of the above-described embodiment, and thus the description thereof will be omitted. In the following description, when viewed from the substrate 10 of the semiconductor device 2, the epitaxial layer 20 side is considered to be the upper side, the cathode electrode or the like 30 side is considered to be the lower side, the central portion 60 side of the semiconductor device 2 is considered to be the inner side, and the termination portion 70 side is considered to be the outer side. In this regard, each of the directions including other directions shall be clearly indicated in the figures.

The semiconductor device 2 according to the second embodiment of the present invention has a configuration in which a trench 510 of the channel current suppression portion 50 is formed in a stepped shape.

That is, as shown in FIGS. 4 and 5, the semiconductor device 2 is provided with the trench 510 provided in the channel current suppression portion 50 such that the trench 510 is cut out in the stepped shape at the terminal portion 70 side on the one surface 20a side of the epitaxial layer 20, and the trench 510 having the stepped shape is configured to expose the lateral side. The trench 510 is provided so as to go around the one surface 20a side of the epitaxial layer 20. An inner surface 510a of the trench 510 having the stepped shape is provided such that the insulating film 35 is bent along the stepped shape, and the trench 510 is insulated from the epitaxial layer 20 in a predetermined manner. The conductive materials 41a2 and 41b2 are filled on the inner surface 510a side of the trench 510 via the insulating film 35. The conductive materials 41a2 and 41b2 are filled on the inner surface 510a side of the trench 510 so as to curve in an arc shape when viewed from the front.

As in the first embodiment described above, the channel current suppression portion 50 of the semiconductor device 2 is provided with an electrode 520 that suppresses the channel current, that is, an EQR (EQuipotential Ring) electrode 520. The EQR electrode 520 is provided so as to go around the one surface 20a side of the epitaxial layer 20. The EQR electrode 520 can be formed of the conductive material. The EQR electrode 520 includes a first electrode portion 520a, a second electrode portion 520b, and a third electrode portion 520c. The first electrode portion 520a, the second electrode portion 520b, and the third electrode portion 520c are continuously provided.

The first electrode portion 520a is provided so as to protrude outward from a bottom portion 510' of the trench 510 having the stepped shape to an upper end portion 510". The first electrode portion 520a has an arcuate shape when viewed from the front. The first electrode portion 520a is directly bonded to the conductive material 51b filled in the trench 510 without interposing the insulating film 35 therebetween. The first electrode portion 520a is formed in the arcuate shape so as to correspond to the filling shape of the conductive materials 41a2 and 41b2.

The second electrode portion 520b is provided along the bottom 510' of the trench 510 having the stepped shape. The second electrode portion 520b is an electrode portion extending in a short shape from the first electrode portion 520a toward the terminal portion 70 side (outer side).

The second electrode portion 520b is directly bonded to the one surface 20a of the epitaxial layer 20. That is, the insulating film 35 is not provided at the termination portion 70 side (outer side) of the bottom portion 510' of the trench 510 having the stepped shape, and the second electrode portion 52b is a portion directly provided on the epitaxial layer 20 without interposing the insulating film 35 therebetween. The EQR electrode 520 is electrically connected to the epitaxial layer 20 via the second electrode portion 520b directly provided on the epitaxial layer 20.

The third electrode portion 520c extends from the first electrode portion 520a toward the central portion 60 side (inner side) along the one surface 20a of the epitaxial layer 20. The third electrode portion 520c is provided in the epitaxial layer 20 via the insulating film 35.

In the semiconductor device 2 of the second embodiment configured as described above, the trench 510 provided in the channel current suppression portion 50 is provided such that the trench 510 is cut out in the stepped shape at the terminal portion 70 side on the one surface 20a side of the epitaxial layer 20, and the trench 510 having the stepped shape is configured to expose the lateral side. Thereby, the resistance increases and the channel current flowing to the termination portion 70 can be further suppressed.

Here, as shown in FIG. 6, the trench 510 having the stepped shape may further include the trench 51 at the bottom 510' in the same manner as in the first embodiment. The second electrode portion 520b of the EQR electrode 520 is provided to close the opening 51c of the trench 51, and is configured to directly bonded to the conductive material 51b filled in the trench 51 without interposing the insulating film 35 therebetween.

By further providing the trench 51 on the bottom portion 510' of the trench 510 having the stepped shape in this way, the channel current flowing to the terminal portion 70 can be further suppressed by the combination of the stepped shape and the trench 51 on the bottom portion 510'.

When the trench 510 is provided in the stepped shape, as shown in FIGS. 7 and 8, the EQR electrode 520 may be bent along the stepped shape of the trench 510 and directly provided on the insulating film 35 without interposing the conductive material 51b therebetween. The resistance increases by the trench 510 having the stepped shape, making it possible to suppress the channel current without providing the conductive material 51b.

MODIFICATION EXAMPLE, APPLICATION EXAMPLE

The present invention is not limited to the above-described embodiments, and the present invention, of course, can be carried out in various modifications and applications within the scope of the claims.

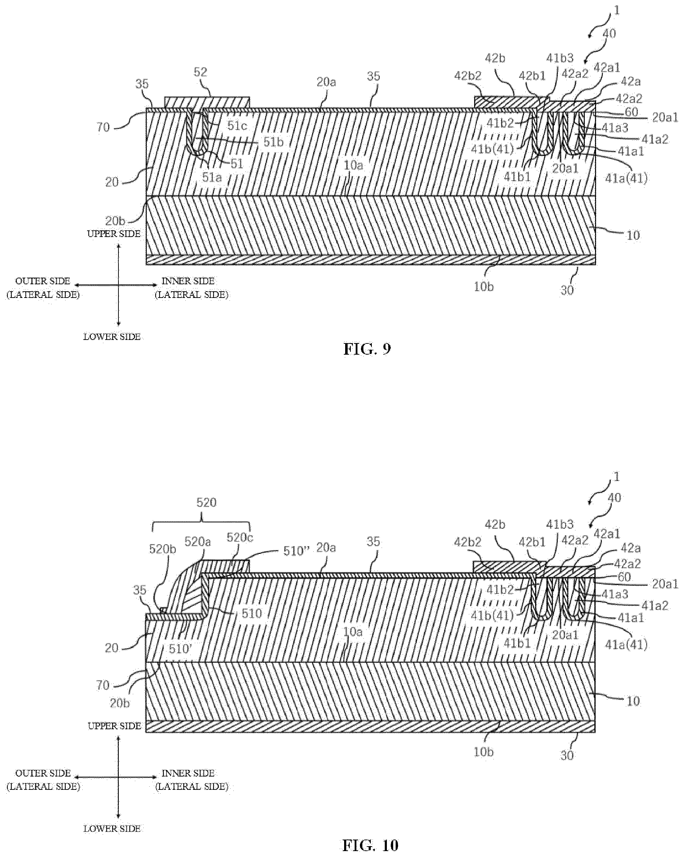

For example, in the above-described embodiments, the EQR electrodes 52, 520 respectively have the second electrode portions 52b, 520b directly provided on the epitaxial layer 20 without interposing the insulating film 35 therebetween. However, as shown in FIGS. 9 to 11, even if the insulating layer 35 is also interposed between the second electrode portions 52b, 520b and the epitaxial layer 20 to insulate the second electrode portions 52b, 520b from the epitaxial layer 20, it is possible to exhibit the required effect for the suppression of the channel current.

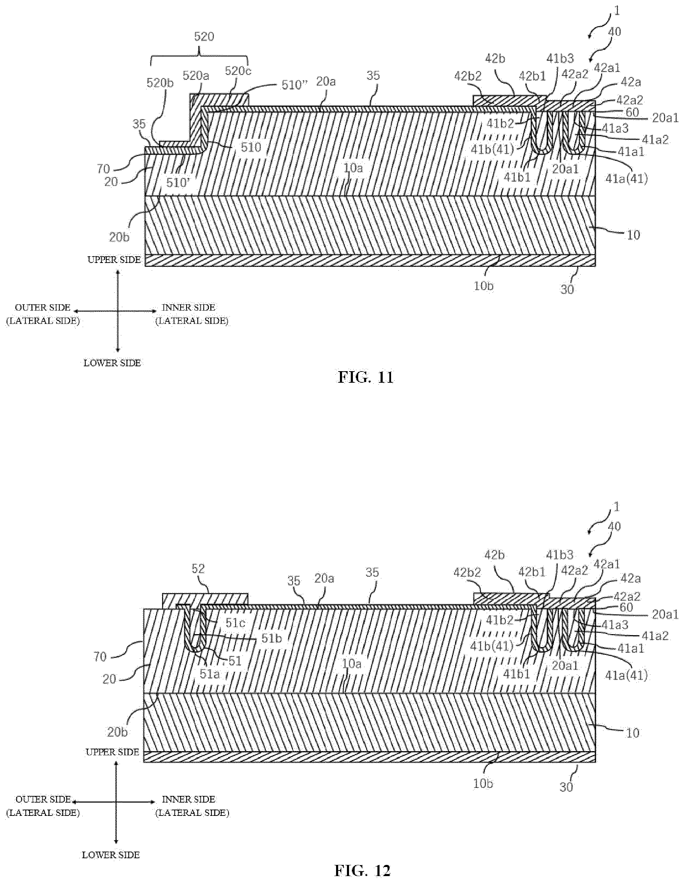

However, in the more preferred embodiments, the EQR electrodes 52 and 520 respectively have the second electrode portions 52b and 520b directly provided on the epitaxial layer 20 without interposing the insulating film 35 therebetween, since the EQR electrodes 52 and 520 and the epitaxial layer 20 can be electrically connected to each other, and the suppression effect of the channel current can be improved. In the first embodiment described above, as shown in FIG. 12, even if the insulating film 35 is extended from the end of the opening 51c of the trench 51 toward the termination portion 70 side in a short length and the insulating layer 35 is partially interposed between the second electrode portion 52b and the epitaxial layer 20, it is possible to exhibit the required effect for suppressing the channel current.

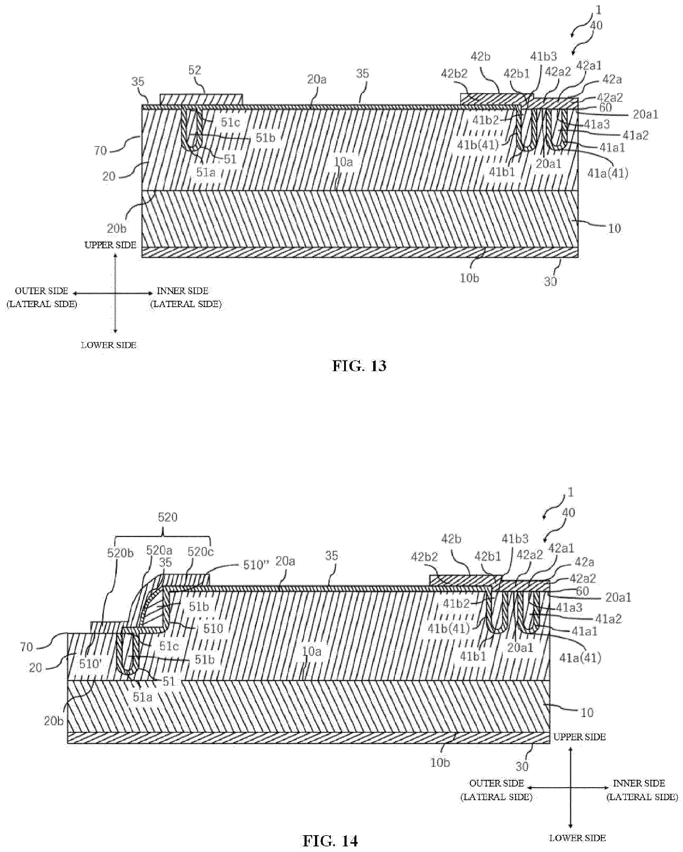

Further, in the above-described embodiments, the first electrode portions 52a and 520a of the EQR electrodes 52 and 520 are directly bonded to the conductive material 51b filled in the trenches 51 and 510 without interposing the insulating film 35 therebetween. However, as shown in FIGS. 13 and 14, even if the first electrode portions 52a and 520a of the EQR electrodes 52 and 520 are insulated from the conductive material 51b by interposing the insulating film 35 therebetween, it is possible to exhibit the required effect for the suppression of the channel current.

However, in the more preferred embodiments, the first electrode portions 52a and 520a of the EQR electrodes 52 and 520 are directly bonded to the conductive material 51b filled in the trenches 51 and 510 without interposing the insulating film 35 therebetween, since the channel current can be surely guided to the trenches 51 and 510.

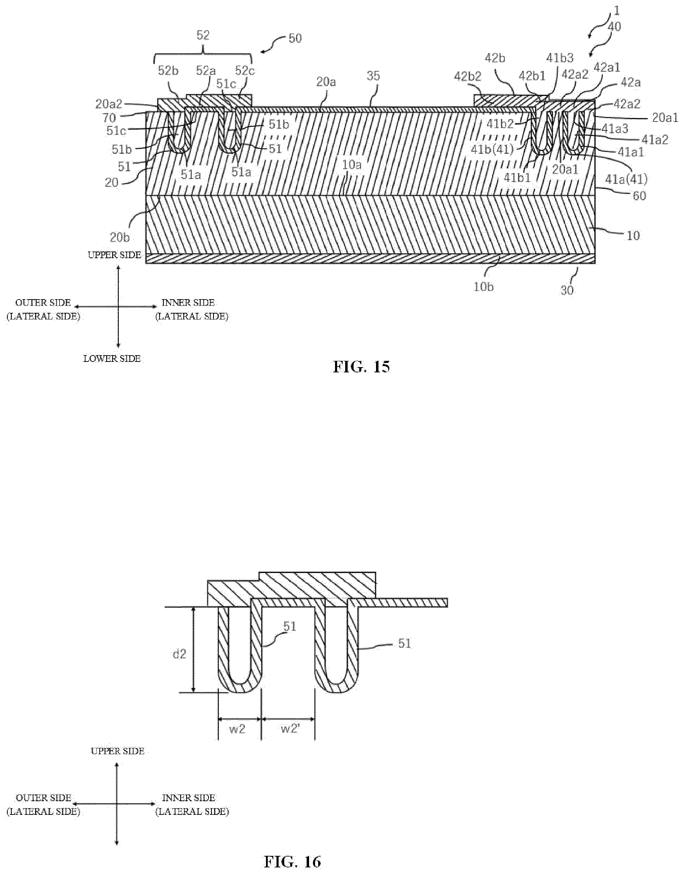

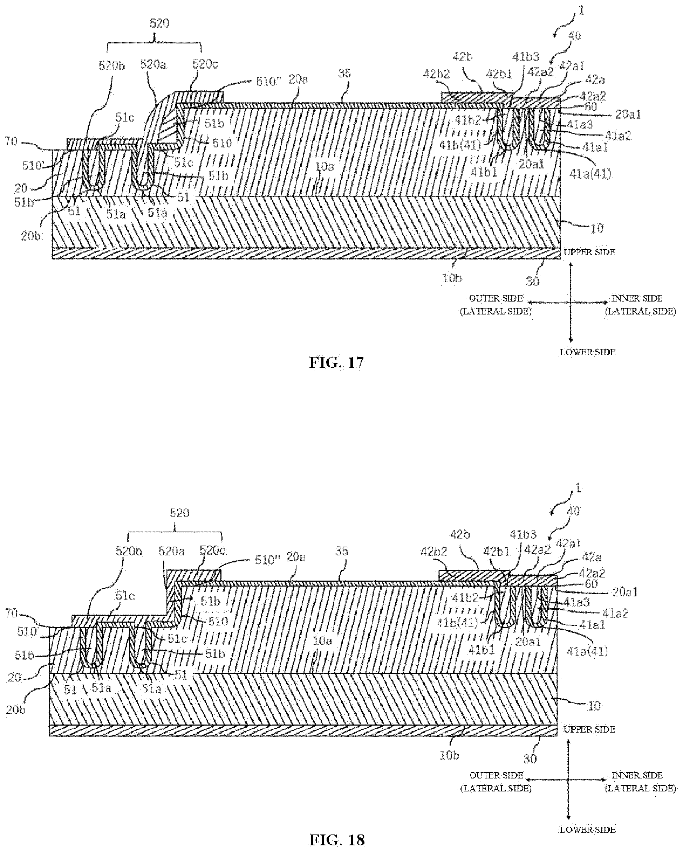

Further, as shown in FIGS. 15 to 18, a plurality of trenches 51 in the channel current suppression portion 50 may be provided along a direction in which the channel current flows. In this case, a more preferred embodiment is to set a mesa width of the trenches 51 (the interval between adjacent trenches 51) w2' to a width dimension greater than the trench width w2. That is, by setting the mesa width w2' of the trenches 51 and 510 to the width dimension greater than the trench width w2, the flow of the channel current can be reliably interrupted by the trenches of the channel current suppression portion 50. The ratio A of the mesa width w2' to the trench width w2 of the trenches 51, 510 shown in the mathematical formula 1 can be, for example, 1.0 to 3.0. Note that even if the mesa width w2' is a width dimension smaller than the trench width w2, it is possible to exhibit the required effect.

[mathematical formula 1]

$$A = w2'/w2$$

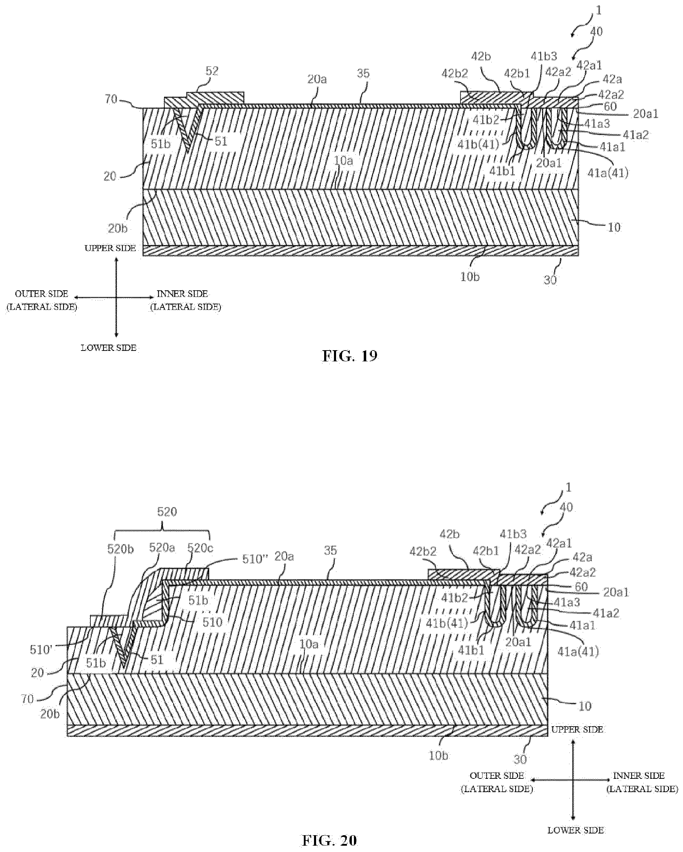

In addition, in the above-described embodiments, each of the trenches 51 and 510 has the U-shaped cross section. However, as shown in FIGS. 19 to 21, each of the trenches 51 and 510 may have a cross-sectional shape different from that of the trench 41 of the active portion 40, such as a triangular shape or another shape. This becomes a more preferable embodiment because it is possible to exhibit the required effect for the suppression of the channel current.

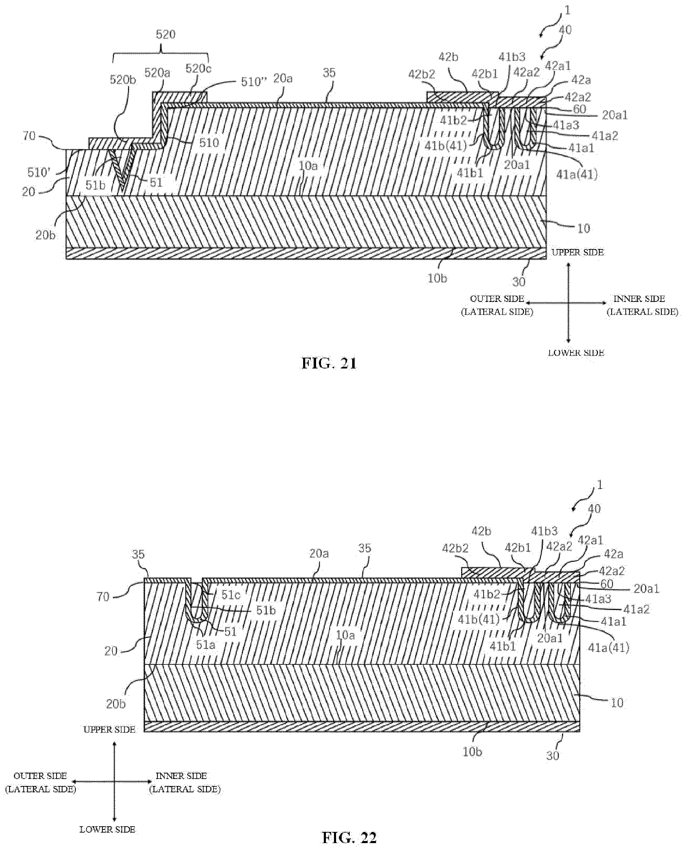

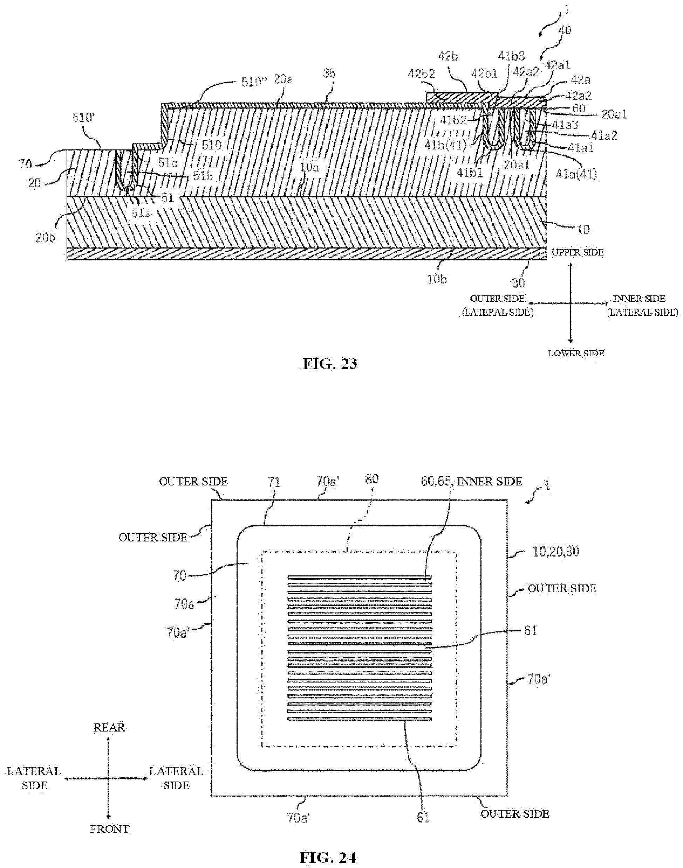

As shown in FIGS. 22 and 23, even if the channel current suppression portion 50 may be formed only by the trenches 51, 510 and the EQR electrodes 52, 520 may be omitted, it is possible to exhibit the required effect for the suppression of the channel current. However, if the EQR electrodes 52 and 520 are provided in the channel current suppression portion 50, the channel current flowing to the termination section 70 can be further suppressed in combination with the effects of the trenches 51 and 510.

Further, in the above-described embodiments, the element provided in the active portion 40 is the diode 42, more specifically to the Schottky barrier diode 42. However, even if the element provided in the active portion 40 may be another diode such as a switching diode or a fast recovery diode, or may be an electronic element other than the diode, it is possible to exhibit the required effect for the suppression of the channel current.

However, since the Schottky barrier diode 42 has the larger performance deterioration caused by the reverse current, it is particularly meaningful to carry out the present invention.

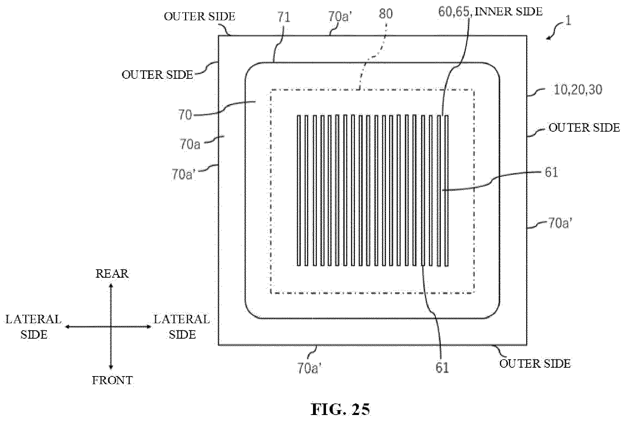

Further, in the above-described embodiments, the trench 61 has the groove shape provided so as to go around the one surface 20a side of the epitaxial layer 20. However, it is not limited to the circulating configuration. For example, it is arranged on a straight line in one direction in the lateral direction as shown in FIG. 24, or arranged on a straight line in one direction in the longitudinal direction as shown in FIG. 25.

**EXPLANATION OF REFERENCE NUMERALS**

A: ratio
w1: width (trench width) dimension
w2: width (trench width) dimension
w2': mesa width
d1: depth dimension
d2: depth dimension
1, 2: semiconductor device
10: substrate
10a: one surface
10b: the other surface
20: epitaxial layer
20a: one surface
20a1: peripheral portion (active portion terminal)
20a2: peripheral portion
20b: the other surface
30: cathode electrode or the like
35 insulating film
40: active portion
41: trench
41a: inner trench
41a1: inner surface
41a2: conductive material
41a3: opening
41b: outer trench
41b1: inner surface
41b2: conductive material
41b3: opening
42: schottky barrier diode (diode)
42a: schottky electrode
42a1: first electrode portion
42a2: second electrode portion
42b: field plate electrode
42b1: first electrode portion
42b2: second electrode portion
50: channel current suppression portion
51, 510: trench
510': bottom portion
510": upper end portion
51a, 510a: inner surface
51b: conductive material
51c: opening
52, 520: EQR electrode (electrode that suppresses channel current)
52a, 520a: first electrode portion
52b, 520b: second electrode portion
52c, 520c: third electrode portion

60: central portion
70: termination portion

## Claims

1. A semiconductor device having a substrate, an epitaxial layer formed on the substrate, and an insulating film provided on one surface side of the epitaxial layer,

    wherein on the one surface side of the epitaxial layer, an active portion provided with a predetermined element and a channel current suppression portion being at a termination portion side and provided outside the active portion are provided via the insulating film, and
    wherein the channel current suppression portion is provided with a trench for suppressing a channel current flowing from the active portion to the termination portion.

2. The semiconductor device according to claim 1, wherein the channel current suppression portion is further provided with an electrode for suppressing the channel current.

3. The semiconductor device according to claim 2, wherein the electrode for suppressing the channel current is an EQR electrode.

4. The semiconductor device according to claim 3, wherein the EQR electrode has a portion directly provided on the epitaxial layer without interposing the insulating film therebetween.

5. The semiconductor device according to claim 1, wherein a trench is provided in the active portion, and a depth dimension and/or a width dimension of the trench provided in the channel current suppression portion is set to be equal to or greater than a depth dimension and/or a width dimension of the trench provided in the active portion.

6. The semiconductor device according to claim 1, wherein the trench provided in the channel current suppression portion is provided so as to be cut out in a stepped shape at the termination portion side on the one surface side of the epitaxial layer, and the trench having the stepped shape is configured to expose a lateral side of an outer side thereof.

7. The semiconductor device according to claim 6, wherein the trench having the stepped shape is further provided with a trench at a bottom thereof.

8. The semiconductor device according to claim 1, wherein a plurality of trenches in the channel current suppression portion are provided along a direction in which the channel current flows.

9. The semiconductor device according to claim 8, wherein a mesa width of the trenches provided in the channel current suppression portion is set to a width dimension greater than a width of the trench.

10. The semiconductor device according to claim 1, wherein the element is a diode.

11. The semiconductor device according to claim 10, wherein the diode is a Schottky barrier diode.

**FIG. 1**

**FIG. 2**

(a)

(b)

d2

51

w2

d1

41

41

w1

w1

UPPER SIDE

OUTER SIDE
(LATERAL SIDE)

INNER SIDE
(LATERAL SIDE)

**FIG. 3**

70  OUTER SIDE  52  2

10,20,30

510

OUTER SIDE

42

41b
(41)

70

42

42

A

A

42

70

OUTER SIDE

INNER SIDE

REAR

41a
(41)

LATERAL
SIDE

LATERAL
SIDE

FRONT

70  OUTER SIDE  60

42

**FIG. 4**

FIG. 5

FIG. 6

FIG. 7

FIG. 8

FIG. 9

FIG. 10

FIG. 11

FIG. 12

FIG. 13

FIG. 14

FIG. 15

FIG. 16

FIG. 17

FIG. 18

FIG. 19

FIG. 20

FIG. 21

FIG. 22

20

FIG. 23

FIG. 24

FIG. 25

**INTERNATIONAL SEARCH REPORT**

| International application No. |
|---|
| **PCT/JP2022/043259** |

**A.    CLASSIFICATION OF SUBJECT MATTER**

*H01L 29/78*(2006.01)i; *H01L 29/06*(2006.01)i; *H01L 29/872*(2006.01)i
FI:    H01L29/78 652N; H01L29/86 301F; H01L29/86 301E; H01L29/78 653A; H01L29/78 652S; H01L29/06 301V;
H01L29/06 301M

According to International Patent Classification (IPC) or to both national classification and IPC

**B.    FIELDS SEARCHED**

Minimum documentation searched (classification system followed by classification symbols)

H01L29/78; H01L29/06; H01L29/872

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C.    DOCUMENTS CONSIDERED TO BE RELEVANT**

| Category* | Citation of document, with indication, where appropriate, of the relevant passages | Relevant to claim No. |
|---|---|---|
| X | US 2013/0228857 A1 (ALPHA AND OMEGA SEMICONDUCTOR INCORPORATED) 05 September 2013 (2013-09-05) paragraphs [0012]-[0017], fig. 2B | 1-3, 6, 7, 9 |
| Y | | 4 |
| A | | 5, 8, 10, 11 |
| X | JP 2013-069866 A (TOSHIBA CORP) 18 April 2013 (2013-04-18) paragraphs [0010]-[0038], fig. 1, 3-9 | 1, 2, 5, 8, 9 |
| A | | 3, 4, 6, 7, 10, 11 |
| X | JP 2011-512676 A (MAXPOWER SEMICONDUCTOR INC) 21 April 2011 (2011-04-21) paragraphs [0017]-[0028], fig. 5-10 | 1, 2, 6, 8 |
| A | | 3-5, 7, 9-11 |

| ✓ Further documents are listed in the continuation of Box C. | ✓ See patent family annex. |
|---|---|

| *    Special categories of cited documents: | "T"    later document published after the international filing date or priority date and not in conflict with the application but cited to understand the principle or theory underlying the invention |
|---|---|
| "A"    document defining the general state of the art which is not considered to be of particular relevance | |
| "E"    earlier application or patent but published on or after the international filing date | "X"    document of particular relevance; the claimed invention cannot be considered novel or cannot be considered to involve an inventive step when the document is taken alone |
| "L"    document which may throw doubts on priority claim(s) or which is cited to establish the publication date of another citation or other special reason (as specified) | "Y"    document of particular relevance; the claimed invention cannot be considered to involve an inventive step when the document is combined with one or more other such documents, such combination being obvious to a person skilled in the art |
| "O"    document referring to an oral disclosure, use, exhibition or other means | |
| "P"    document published prior to the international filing date but later than the priority date claimed | "&"    document member of the same patent family |

| Date of the actual completion of the international search | Date of mailing of the international search report |
|---|---|
| **02 February 2023** | **14 February 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (January 2015)

**INTERNATIONAL SEARCH REPORT**

International application No.

**PCT/JP2022/043259**

C. **DOCUMENTS CONSIDERED TO BE RELEVANT**

| Category* | Citation of document, with indication, where appropriate, of the relevant passages | Relevant to claim No. |
|---|---|---|
| X | US 2015/0333133 A1 (NXP B.V.) 19 November 2015 (2015-11-19) paragraphs [0053]-[0075], fig. 2a | 1, 2, 5, 8, 10, 11 |
| Y | | 1-5, 8, 10, 11 |
| A | | 6, 7, 9 |
| Y | JP 6-112216 A (TOSHIBA CORP) 22 April 1994 (1994-04-22) paragraphs [0008], [0015]-[0031], [0036], [0037], [0052], [0053], fig. 1-3, 6 | 1-5, 8, 10, 11 |
| A | | 6, 7, 9 |
| A | JP 2013-243213 A (DENSO CORPORATION) 05 December 2013 (2013-12-05) paragraphs [0016]-[0052], fig. 1-4 | 1-11 |

Form PCT/ISA/210 (second sheet) (January 2015)

**INTERNATIONAL SEARCH REPORT**
Information on patent family members

International application No.

**PCT/JP2022/043259**

| Patent document cited in search report | | | Publication date (day/month/year) | Patent family member(s) | | | Publication date (day/month/year) |
|---|---|---|---|---|---|---|---|
| US | 2013/0228857 | A1 | 05 September 2013 | CN | 103151382 | A | |
| | | | | paragraphs [0037]-[0042], fig. 2B | | | |
| | | | | TW | 201340326 | A | |
| JP | 2013-069866 | A | 18 April 2013 | (Family: none) | | | |
| JP | 2011-512676 | A | 21 April 2011 | US | 2009/0206913 | A1 | |
| | | | | paragraphs [0040]-[0051], fig. 5-10 | | | |
| | | | | EP | 2248158 | A2 | |
| | | | | CN | 102007584 | A | |
| | | | | TW | 200945584 | A | |
| US | 2015/0333133 | A1 | 19 November 2015 | EP | 2945192 | A1 | |
| | | | | paragraphs [0022]-[0043], fig. 2a | | | |
| | | | | CN | 105895709 | A | |
| JP | 6-112216 | A | 22 April 1994 | (Family: none) | | | |
| JP | 2013-243213 | A | 05 December 2013 | US | 2015/0072485 | A1 | |
| | | | | paragraphs [0027]-[0059], fig. 1-4 | | | |
| | | | | WO | 2013/172032 | A1 | |
| | | | | EP | 2851939 | A1 | |

Form PCT/ISA/210 (patent family annex) (January 2015)

**EP 4 451 343 A1**

## REFERENCES CITED IN THE DESCRIPTION

**Patent documents cited in the description**

- JP 2009130002 A